(19) Europäisches Patentamt
European Patent Office
Office européen des brevets

(11) EP 0 440 957 B1

(12) # EUROPÄISCHE PATENTSCHRIFT

(45) Veröffentlichungstag und Bekanntmachung des Hinweises auf die Patenterteilung:
**27.03.1996 Patentblatt 1996/13**

(51) Int. Cl.$^6$: **C08G 61/12**, C08L 65/00, C08J 7/00, G03C 1/89

(21) Anmeldenummer: **90124841.9**

(22) Anmeldetag: **20.12.1990**

(54) **Neue Polythiophen-Dispersionen, ihre Herstellung und ihre Verwendung**

New polythiophene dispersions, their preparation and their use

Dispersions de polythiophènes nouvelles, leur préparation et leur utilisation

(84) Benannte Vertragsstaaten:
**DE FR GB IT**

(30) Priorität: **08.02.1990 DE 4003720**

(43) Veröffentlichungstag der Anmeldung:
**14.08.1991 Patentblatt 1991/33**

(73) Patentinhaber: **BAYER AG**
**D-51368 Leverkusen (DE)**

(72) Erfinder:
- **Jonas, Friedrich, Dr.**
  **W-5100 Aachen (DE)**
- **Krafft, Werner, Dr.**
  **W-5090 Leverkusen 1 (DE)**

(56) Entgegenhaltungen:
**EP-A- 229 992**
**EP-A- 0 253 594**
**EP-A- 0 339 340**

- **PATENT ABSTRACTS OF JAPAN, unexamined applications, Sektion C, Band 13, Nr.182, 27. April 1989 THE PATENT OFFICE JAPANESE GOVERNMENT Seite 94 C 591**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 440 957 B1

Printed by Rank Xerox (UK) Business Services
2.9.16/3.4

## Beschreibung

Die Erfindung betrifft neue Polythiophen-Dispersionen, ihre Herstellung und ihre Verwendung zur antistatischen Ausrüstung von Kunststoff-Formteilen.

Thiophenpolymere und deren Verwendung zur antistatischen Ausrüstung von Kunststoff-Formteilen und als organische Leiter in elektronischen Geräten und Kondensatoren sind bekannt (siehe z.B. die EP-A 253 594, 328 983, 328 981, 339 340 und 340 512).

In der EP-A 253 594 sind in 3,4-Stellung durch bestimmte Gruppen substituierte Polythiophene zusammen mit monomolekularen Säuren (nachfolgend als Monosäuren bezeichnet) und hochmolekularen Säuren (nachfolgend als Polysäuren bezeichnet) beschrieben. Die Polymere bilden, unabhängig davon, ob sie in Gegenwart von Mono- oder Polysäuren vorliegen, in Wasser und zum Teil auch in aprotischen organischen Lösungsmitteln unlösliche Pulver oder Filme. Solche unlöslichen Pulver und Filme kommen für eine antistatische Ausrüstung von Kunststoff-Formteilen nicht in Betracht.

In der EP-A 328 983 sind in aprotischen organischen Lösungsmitteln lösliche, von in 3,4-Stellung durch bestimmte Gruppen substituierten Polythiophenen mit Monosäuren und in der EP-A 328 981 die Verwendung dieser Gemische in elektrisch leitenden Beschichtungsmassen beschrieben. Die Gemische werden nach einem aufwendigen Verfahren, nämlich durch elektrochemische Oxidation der entsprechenden monomeren Thiophene in Gegenwart von Leitsalzen, hergestellt. Zur antistatischen Ausrüstung von Kunststoff-Formteilen werden diese Polythiophen-Salze in Form ihrer Lösungen in organischen aprotischen Lösungsmitteln auf die Formteile aufgebracht.

In der EP-A 339 340 sind Gemische von in 3,4-Stellung durch bestimmte Gruppen substituierten Polythiophenen mit Monosäuren und in der EP-A 340 512 deren Verwendung als Feststoffelektrolyte in Kondensatoren beschrieben. Zur antistatischen Ausrüstung von Kunststoff-Formteilen werden die in der EP-A 339 340 beschriebenen Polythiophene unmittelbar auf den Formteilen durch chemische Oxidation der entsprechenden Thiophen-Derivate in situ erzeugt. Je nach verwendetem Oxidationsmittel können Oxidationsmittel und monomeres Thiophen aus getrennten Lösungen nacheinander oder aber aus einer Lösung gemeinsam auf die Formteile aufgebracht werden.

Die bislang bekannten Polythiophene weisen zwar gute elektrische Eigenschaften auf und verleihen auch, sofern sie sich auf Kunststoff-Formteile aufbringen lassen, diesen Kunststoff-Formteilen gute antistatische Eigenschaften, aber sie entsprechen trotzdem nicht den technischen Anforderungen, weil die Praxis ein Aufbringen von Antistatikausrüstungen aus wäßrigem Medium anstrebt und außerdem verlangt wird, daß für die wäßrigen Zubereitungen lange Standzeiten und gute Verarbeitungseigenschaften aufweisen, d.h. sich mit hohen Arbeitsgeschwindigkeiten aufbringen lassen und nach dem Aufbringen innerhalb möglichst kurzer Zeit die gewünschte antistatische Beschichtung liefern.

Hingegen weisen Polythiophene aus Thiophen oder Benzisothiophen (EP-A 229 992) nicht die erforderlichen elektrischen Eigenschaften auf.

Überraschenderweise wurde gefunden, daß die den in der EP-A 340 512 beschriebenen Polythiophenen zugrunde liegenden Thiophene in Gegenwart von Polysäuren nicht nur mit hoher Geschwindigkeit polymerisieren, sondern daß auch in Wasser beständige Zubereitungen mit den gewünschten guten Verarbeitungseigenschaften erhalten werden, und daß man mit Hilfe dieser Zubereitungen transparente, von der Luftfeuchtigkeit unabhängige antistatische Überzüge auf Kunststoff-Formteilen erzeugen kann.

Als Lösungsmittel für diese Zubereitungen kommen neben Wasser auch andere protische Lösungsmittel in Betracht, z.B. niedere Alkohole wie Methanol, Ethanol und Isopropanol sowie Mischungen von Wasser mit niederen Alkoholen und anderen mit Wasser mischbaren organischen Lösungen wie Aceton in Betracht.

Die mittleren Teilchendurchmesser der Dispersionspartikel kann bis 10 µm reichen; vorzugsweise reichen sie bis 3 µm und ganz besonders bevorzugt bis 1 µm.

Haben die Partikel größere Teilchendurchmesser, so kommt auf den Kunststoffoberflächen zum antistatischen Effekt durch die Ladungen der Partikel noch ein Abstandshaltereffekt, insbesondere bei fotografischen Materialien hinzu.

Die Erfindung betrifft daher Dispersionen von Polythiophenen, die aus Struktureinheiten der Formel

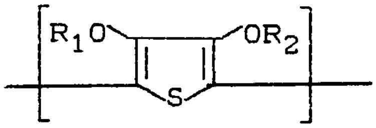 (I),

aufgebaut sind, in der

$R_1$ und $R_2$ zusammen einen gegebenenfalls substituierten $C_1$-$C_4$-Alkylen-Rest, vorzugsweise einen gegebenenfalls durch Alkylgruppen substituierten Methylen-, einen gegebenenfalls durch $C_1$-$C_{12}$-Alkyl-

oder Phenylgruppen substituierten Ethylen-1,2-Rest, einen Propylen-1,3-Rest oder einen Cyclohexylen-1,2-Rest bilden,

in Gegenwart von Polyanionen der Polystyrolsulfonsäure.

Als Vertreter der gegebenenfalls substituierten $C_1$-$C_4$-Alkylenreste, die $R_1$ und $R_2$ zusammen bilden können, seien vorzugsweise die Alkylen-1,2-Reste genannt, die sich von den 1,2-Dibrom-alkanen ableiten, wie sie beim Bromieren von $\alpha$-Olefinen, wie Ethen, Propen-1, Hexen-1, Octen-1, Decen-1, Dodecen-1 und Styrol erhältlich sind; außerdem seien genannt der Cyclohexylen-1,2-, Butylen-2,3-, 2,3-Dimethyl-butylen-2,3- und Pentylen-2,3-Rest.

Bevorzugte Reste für $R_1$ und $R_2$ sind der Methylen-, Ethylen-1,2- und Propylen-1,3-Rest, besonders bevorzugt ist der Ethylen-1,2-Rest.

Das Molekulargewicht der die Polyanionen liefernden Polystyrolsulfonsäure beträgt vorzugsweise 1000 bis 2 000 000, besonders bevorzugt 2000 bis 500 000. Die Polystyrolsulfonsäure ist im Handel erhältlich oder nach bekannten Verfahren herstellbar (siehe z.B. Houben-Weyl, Methoden der organischen Chemie, Bd. E 20 Makromolekulare Stoffe, Teil 2, (1987), S. 1141 u.f.).

Die erfindungsgemäßen Polythiophen-Dispersionen in Gegenwart von Polyanionen werden durch oxidative Polymerisation von Verbindungen der Formel

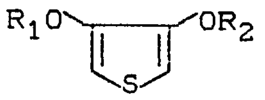

(II),

in der

R₁ und R₂ die unter Formel (I) angegebene Bedeutung haben,

mit für die oxidative Polymerisation von Pyrrol üblichen Oxidationsmitteln und/oder Sauerstoff oder Luft in Gegenwart der Polystyrolsulfonsäure, bevorzugt in wäßrigem Medium, bei Temperaturen von 0 bis 100°C erhalten. Durch die oxidative Polymerisation erhalten die Polythiophene positive Ladungen, die in den Formeln nicht dargestellt sind, da ihre Zahl und ihre Position nicht einwandfrei feststellbar sind.

Zur Polymerisation werden die Thiophene der Formel (II), Polystyrolsulfonsäure und Oxidationsmittel in einem organischen Lösungsmittel oder - vorzugsweise -in Wasser gelöst und die Lösung solange bei der vorgesehenen Polymerisationstemperatur gerührt, bis die Polymerisation abgeschlossen ist.

Bei Verwendung von Luft oder Sauerstoff als Oxidationsmittel wird in die Thiophen, Polystyrolsulfonsäure und gegebenenfalls katalytische Mengen an Metallsalzen enthaltende Lösung solange Luft oder Sauerstoff eingeleitet bis die Polymerisation abgeschlossen ist.

In Abhängigkeit von Ansatzgröße, Polymerisationstemperatur und Oxidationsmittel kann die Polymerisationszeit zwischen wenigen Minuten und bis zu 30 Stunden betragen. Im allgemeinen liegt die Zeit zwischen 30 Minuten und 10 Stunden. Die Stabilität der Dispersionen läßt sich durch, während oder nach der Polymerisation zugefügte Dispergatoren wie Dodecylsulfonat verbessern.

Die nach der Polymerisation vorliegenden Zubereitungen können unmittelbar zur Antistatikausrüstung der Kunststoff-Formteile verwendet, d.h. unmittelbar auf diese Formteile nach bekannten Verfahren, z.B. durch Tränken, Besprühen, Tiefdruck, Rakeln, Streichen usw. aufgebracht werden. Nach dem Entfernen des Lösungsmittels, z.B. des Wassers, liegt unmittelbar die von dem Polythiophen auf dem behandelten Formteil gebildete, von der Luftfeuchtigkeit unabhängige antistatische Schicht vor.

Als Oxidationsmittel können die für die oxidative Polymerisation von Pyrrol geeigneten Oxidationsmittel verwendet werden; diese sind beispielsweise in J. Am. Chem. Soc. 85, 454 (1963) beschrieben. Bevorzugt sind aus praktischen Gründen preiswerte und leicht handhabbare Oxidationsmittel, z.B. Eisen-III-Salze wie $FeCl_3$, $Fe(ClO_4)_3$ und die Eisen-III-Salze organischer Säuren und organische Reste aufweisender anorganischer Säuren, ferner $H_2O_2$, $K_2Cr_2O_7$, Alkali- und Ammoniumpersulfate, Alkaliperborate, Kaliumpermanganat und Kupfersalze, wie Kupfertetrafluoroborat, Außerdem wurde gefunden, daß sich Luft und Sauerstoff, gegebenenfalls in Gegenwart katalytischer Mengen Metallionen, wie Eisen-, Cobalt-, Nickel-, Molybdän- und Vanadiumionen, mit Vorteil als Oxidationsmittel verwenden lassen.

Die Verwendung der Persulfate und der Eisen-III-salze organischer Säuren und der organische Reste aufweisenden anorganischen Säuren hat den großen anwendungstechnischen Vorteil, daß sie nicht korrosiv wirken.

Als Eisen-III-Salze organische Reste aufweisender anorganischer Säuren seien beispielsweise die Eisen-III-Salze der Schwefelsäurehalbester von $C_1$-$C_{20}$-Alkanolen, z.B. das Fe-III-Salz des Laurylsulfates genannt.

Als Eisen-III-Salze organischer Säuren seien beispielsweise genannt; die Fe-III-Salze von $C_1$-$C_{20}$-Alkylsulfonsäuren, wie der Methan- und der Dodecansulfonsäure; aliphatischen $C_1$-$C_{20}$-Carbonsäuren wie der 2-Ethylhexylcarbonsäure; aliphatischen Perfluorcarbonsäuren, wie der Trifluoressigsäure und der Perfluoroctansäure; aliphatischen Dicarbonsäuren, wie der Oxalsäure und vor allem von aromatischen, gegebenenfalls durch $C_1$-$C_{20}$-Alkylgruppen substituierten Sulfonsäuren wie der Benzolsulfonsäure, p-Toluolsulfonsäure und der Dodecylbenzolsulfonsäure.

Es können auch Gemische dieser vorgenannten Fe-III-Salze organischer Säuren eingesetzt werden.

Für die oxidative Polymerisation der Thiophene der Formel II werden theoretisch je Mol Thiophen 2,25 Äquivalente Oxidationsmittel benötigt (siehe z.B. J. Polym. Sc. Part A Polymer Chemistry Vol. 26, S. 1287 (1988)).

Praktisch wird das Oxydationsmittel jedoch in einem gewissen Überschuß, z.B. einem Überschuß von 0,1 bis 2 Äquivalenten je Mol Thiophen angewendet.

Bei der oxidativen Polymerisation wird die erfindungsgemäß zu verwendenden Polystyrolsulfonsäure in einer solchen Menge eingesetzt, daß auf 1 Mol Thiophen der Formel (II) 0,25 bis 10, vorzugsweise 0,8 bis 8, Säuregruppen der Polystyrolsulfonsäure entfallen.

Für die oxidative Polymerisation werden die Thiophene der Formel (II) und die Polystyrolsulfonsäure in einer solchen Menge Lösungsmittel gelöst, so daß stabile Polythiophen-Dispersionen erhalten werden, deren Feststoffgehalt zwischen 0,5 und 55 Gew.-%, vorzugsweise 5 bis 30 Gew.-%, beträgt.

Zur Erzielung besser haftender und kratzfester Beschichtungen können den Polythiophen-Salz-Zubereitungen auch noch wasserlösliche, bzw. in Wasser suspendierbare polymere Bindemittel, z.B. Polyvinylalkohol oder Polyvinylacetat-Dispersionen zugesetzt werden.

Bei säureempfindlichen Kunststoff-Formteilen und zur Schonung der zum Aufbringen verwendeten Geräte kann es vorteilhaft sein, in den erfindungsgemäßen Polythiophen-Salz-Zubereitungen vor dem Aufbringen auf die Kunststoff-Formteile überschüssige freie Säuregruppen durch Zugabe von Alkali- oder Erdalkalihydroxiden, Ammoniak oder Aminen zu neutralisieren.

Die Dicke der Schichten, in denen die erfindungsgemäßen Polythiophen-Dispersionen auf die antistatisch auszurüstenden Kunststoff-Formteile aufgebracht werden, beträgt nach dem Trocknen in Abhängigkeit von der gewünschten Leitfähigkeit des Formkörpers und der gewünschten Transparenz der Beschichtung 0,001 bis 100 µm.

Das Entfernen der Lösungsmittel nach dem Aufbringen der Lösungen kann durch einfaches Abdampfen bei Raumtemperatur erfolgen. Zur Erzielung höherer Verarbeitungsgeschwindigkeiten ist es jedoch vorteilhafter, die Lösungsmittel bei erhöhten Temperaturen, z.B. bei Temperaturen von 20 bis zu 150°C, bevorzugt 40 bis zu 100°C, zu entfernen.

Die Herstellung der Polythiophendispersionen kann in Gegenwart von Polymerlatices bzw. Polymerdispersionen erfolgen, die saure Gruppen (Salze) wie $-SO_3^-$, $-COO^-$, $-PO_3^{2-}$ aufweisen. Der Gehalt an sauren Gruppen liegt vorzugsweise über 2 Gew.-%, um eine ausreichende Stabilität der Dispersion zu gewährleisten. Die Teilchengrößen der Dispersionen liegen im Bereich von 10 nm bis 1 µm, vorzugsweise im Bereich von 40 bis 400 nm.

Polymere die für diesen Zweck geeignet sind werden beispielsweise in DE-A 25 41 230, DE-A 25 41 274, DE-A 28 35 856, EP-A-0 014 921, EP-A-0 069 671, EP-A-0 130 115, US-A-4 291 113 beschrieben.

Die Polymerdispersionen bzw. Latices können aus linearen, verzweigten oder vernetzten Polymeren bestehen. Die vernetzten Polymerlatices mit hohem Gehalt an sauren Gruppen sind in Wasser quellbar und werden als Mikrogele bezeichnet. Derartige Mikrogele werden beispielsweise in US 4 301 240, US 4 677 050 und US 4 147 550 beschrieben.

Als Substrate, die nach dem erfindungsgemäßen Verfahren antistatisch bzw. elektrisch-leitfähig ausgerüstet werden, seien vor allem Formkörper aus organischen Kunststoffen, insbesondere Folien aus Polycarbonaten, Polyamiden, Polyethylenen, Polypropylenen, Polyvinylchlorid, Polyestern, Celluloseacetat und Cellulose genannt, aber auch anorganische Werkstoffe, z.B. Glas oder keramische Wirkstoffe aus Aluminiumoxid und/oder Siliciumdioxid sind nach dem erfindungsgemäßen Verfahren antistatisch ausrüstbar.

Die erfindungsgemäßen Polythiophendispersionen können auch zur antistatischen Ausrüstung von heißsiegelfähigen Folien, wie sie in DE-A 38 38 652 beschrieben sind, eingesetzt werden.

Wegen ihrer Transparenz eignen sich die erfindungsgemäß erhältlichen Beschichtungen insbesondere zur antistatischen Ausrüstung von fotografischen Materialien, insbesondere Filmen, z.B. Schwarz-Weiß-, Colornegativ- und Umkehrfilmen, vorzugsweise in Form einer Rückseitenschicht, das heißt, in einer Schicht, die auf der den Silberhalogenidemulsionsschichten abgewandten Seite des Schichtträgers aufgebracht wird.

Die Polythiophendispersion wird vorzugsweise in einer Menge von 0,01 bis 0,3 $g/m^2$, vorzugsweise 0,02 bis 0,2 $g/m^2$ aufgetragen.

Ein weiterer Gegenstand der Erfindung ist ein fotografisches Material, das eine Antistatikschicht mit einer erfindungsgemäßen Polythiophendispersion aufweist.

Beispiel 1

In eine Lösung aus 2,0 g (11 mmol $SO_3H$-Gruppen) Polystyrolsulfonsäure ($\overline{M}G$ 4000), 0,5 g 3,4-Ethylendioxythiophen (3,5 mmol) und 0,05 g Eisen-III-sulfat (0,2 mmol) in 20 ml Wasser wird 24 Stunden bei Raumtemperatur Luft eingeleitet; in dieser Zeit färbt sich die Reaktionsmischung hellblau.

Anschließend wird die Zubereitung mit einem Handcoater (Naßfilmdicke 25 µm entsprechend einer Trockenfilmdicke von etwa 2,5 µm) auf eine Polycarbonatfolie aufgerakelt. Die beschichtete Folie wird bis zur Gewichtskonstanz getrocknet und anschließend bei 0 % rel. Feuchte 24 Stunden gelagert.

Es wird eine transparente, hellblau gefärbte Folie erhalten; Oberflächenwiderstand ($R_{OB}$) der Folie: $10^7$ Ω (bei 0 % rel. Feuchte).

Wird die Folie in gleicher Weise mit einer auf ein Drittel verdünnten Zubereitung beschichtet (Trockenfilmdicke der Beschichtung; etwa 1 µm), so wird eine transparente, schwach hellblau gefärbte Folie erhalten; Oberflächenwiderstand ($R_{OB}$) der Folie: $10^8$ Ω (bei 0 % rel. Feuchte).

Wird die Polycarbonatfolie mit der Polythiophen-Zubereitung beschichtet, deren pH-Wert mit 10 gew.-%iger Natronlauge auf 8 eingestellt worden war (Trockenfilmdicke; etwa 1,5 µm), so wird ebenfalls eine transparente, hellblau gefärbte Folie erhalten; Oberflächenwiderstand ($R_{OB}$) der Folie; 3 x $10^7$ Ω (bei 0 % rel. Feuchte).

Wird die Folie mit einer 10 gew.-%igen Lösung von Polystyrolsulfonsäurenatriumsalz (handelsübliches Antistatikum) beschichtet (Trockenfilmdicke; etwa 2,5 µm), so beträgt der Oberflächenwiderstand ($R_{OB}$) der Folie > $10^9$ Ω (bei 0 % rel. Feuchte).

Beispiel 2

Die Lösung von 2,7 g (0,01 Mol) Kaliumperoxidisulfat in 50 ml Wasser wird unter Rühren mit 1,8 g (0,01 Mol $SO_3H$) Polystyrolsulfonsäure ($\overline{M}$G 4000) und 1,4 g (0,01 Mol) 3,4-Ethylendioxy-thiophen versetzt und anschließend 24 Stunden bei Raumtemperatur gerührt. Anschließend wird die Zubereitung mit 300 ml Wasser verdünnt und auf eine Cellulosetriacetatfolie aufgerakelt. Die beschichtete Folie wird bei Raumtemperatur bis zur Gewichtskonstanz getrocknet und anschließend 24 Stunden bei 0 % rel. Feuchte gelagert.

Trockenfilmdicke der Beschichtung; etwa 0,5 µm; es wird eine fast farblose transparente Folie erhalten; Oberflächenwiderstand ($R_{OB}$) der Folie; 2 x $10^7$ Ω.

Beispiel 3

In die Lösung aus 10 g (54 mmol $SO_3H$) Polystyrolsulfonsäure ($\overline{M}$G 4000), 0,25 g (1 mmol) Fe-III-Sulfat und 2,5 g (0,18 mmol) 3,4-Ethylendioxy-thiophen in 100 ml Wasser wird unter Rühren bei 60°C 8 Stunden Luft eingeleitet.

Mit der so erhaltenen hellblauen Zubereitung wird eine Polycarbonatfolie beschichtet; die Folie wird bei 70°C vom Lösungsmittel befreit (Trockenfilmdicke; etwa 2,5 µm). Die Folie wird 24 Stunden bei 0 % rel. Feuchte gelagert. Es wird eine transparente, schwach hellblau gefärbte Folie erhalten; Oberflächenwiderstand ($R_{OB}$) der Folie; 2 x $10^6$ Ω.

Wird die Polycarbonatfolie mit der mit Wasser auf ein Drittel verdünnten hellblauen Zubereitung beschichtet, so weist die erhaltene farblose transparente Folie einen Oberflächenwiderstand ($R_{OB}$) von 8 x $10^6$ Ω auf.

Beispiel 4

Eine gemäß Beispiel 3 hergestellte Polythiophen-Zubereitung wird mit einem 1:1-Methanol-Wasser-Gemisch auf einen Feststoffgehalt von 0,8 Gew.-% verdünnt. Diese Zubereitung wird auf einer Gießmaschine mittels einer üblichen Anspülwalze auf eine mit einer handelsüblichen Haftschicht versehene Polyesterfilmunterlage aufgetragen. Der beschichtete Film wird bei 70°C getrocknet; der Feststoffauftrag auf dem Film beträgt nach dem Trocknen 150 mg/m².

Die fast farblose, transparente Antistatikschicht weist bei 0 % relativer Feuchtigkeit einen Oberflächenwiderstand ($R_{OB}$) von 3 x $10^6$ Ω auf.

Eine gleichwertige Antistatikbeschichtung wird bei gleichem Auftrag auch auf einer mit einer handelsüblichen Haftschicht versehene Triacetatfilmunterlage erhalten.

Beispiel 5

In die Lösung von 6 g (30 mmol $SO_3H$) Polystyrolsulfonsäure ($\overline{M}$G 4000), 0,15 g (0,6 mmol) Eisen-III-sulfat und 1,0 g (7 mmol) 3,4-Ethylendioxythiophen in 100 ml Wasser wird bei 80°C 6 Stunden lang Luft eingeleitet.

Die Polymerisationsmischung wird nach dem Abkühlen auf Raumtemperatur mit einem 1:1-Methanol-Wasser-Gemisch auf einen Feststoffgehalt von 4 Gew.-% verdünnt.

Diese Zubereitung wird wie in Beispiel 4 beschrieben auf eine mit einer handelsüblichen Haftschicht versehene Polyethylenterephthalat-Folie aufgebracht. Der Feststoffauftrag beträgt nach dem Trocknen bei 70°C etwa 60 mg/m². Die fast farblose, transparente Antistatikbeschichtung weist bei 0 % relativer Feuchtigkeit einen Oberflächenwiderstand 5 x $10^8$ Ω auf.

Beispiel 6

In die Lösung von 5 g (26 mmol $SO_3H$) Polystyrolsulfonsäure ($\overline{M}$G 4000) und 0,6 g (4 mmol) 3,4-Ethylendioxythiophen in 50 ml Wasser wird bei 50°C 24 Stunden lang Luft eingeleitet. Die so erhaltene Polymerisationsmischung wird mit einem Handcoater auf eine Polycarbonatfolie aufgerakelt (Naßfilmdicke; 25 µm entsprechend einer Trockenfilmdicke von etwa 2,5 µm). Die beschichtete Folie wird bis zur Gewichtskonstanz getrocknet.

Der Oberflächenwiderstand der Folie beträgt bei 0 % relativer Feuchtigkeit $10^9$ Ω.

Beispiel 7

In die Lösung von 5,5 g (26 mmol $SO_3Na$) Polystyrolsulfonsäure- ($\overline{M}$G 4000) -$Na^+$-Salz, 3,0 g (17 mmol) p-Toluolsulfonsäure, 2,5 g (17 mmol) 3,4-Ethylendioxythiophen und 0,25 g (1 mmol) Eisen-III-sulfat in 100 ml Wasser wird 16 Stunden bei 40 bis 50°C unter Rühren Luft eingeleitet.

Die erhaltene Polythiophen-Zubereitung wird anschließend mit 200 ml Wasser und 100 ml Methanol verdünnt und auf eine Polycarbonatfolie aufgerakelt.

Die Beschichtung weist nach dem Trocknen (Trockenfilmdicke etwa 0,7 µm) einen Oberflächenwiderstand ($R_{OB}$) von 7 x $10^7$ Ω auf.

Beispiel 8

Die gemäß Beispiel 7 bereitete Polythiophen-Zubereitung wird mit 400 ml Wasser verdünnt und nach Zugabe von 5,0 g Polyvinylalkohol solange gerührt, bis eine homogene Zubereitung entstanden ist.

Die Zubereitung wird auf eine Polycarbonatfolie aufgerakelt. Nach dem Trocknen (Trockenfilmdicke etwa 0,7 µm) weist die Antistatikbeschichtung einen Oberflächenwiderstand ($R_{OB}$) von 1,5 x $10^8$ Ω (bei 0° relativer Feuchtigkeit) auf.

Beispiel 9

Auf eine vorderseitig mit einer Haftschicht versehenen transparenten Triacetat-Unterlage von 125 µm Stärke wird auf die Vorderseite ein lichtempfindlicher Mehrschichtenaufbau der nachstehenden Zusammensetzung gegossen.

Die Mengenangaben beziehen sich jeweils auf 1 $m^2$; der Silberhalogenid-Auftrag entspricht der äquivalenten Menge $AgNO_3$; alle Silberhalogenid-Emulsionen sind mit 0,1 g 4-Hydroxy-6-methyl-1,3,3a,7-tetra-azainden pro 100 g $AgNO_3$ stabilisiert.

Schichtaufbau: (Vorderseite)

1. Schicht: (Antihaloschicht)

| | |
|---|---|
| 0,2 g | schwarzes Kolloidales Silber |
| 1,2 g | Gelatine |
| 0,1 g | UV-Absorber UV 1 |
| 0,2 g | UV-Absorber UV 2 |
| 0,02 g | Trikresylphosphat |
| 0,03 g | Dibutylphthalat |

2. Schicht: (Mikrat-Zwischenschicht)

| | |
|---|---|
| 0,25 g | $AgNO_3$ einer Mikrat-Ag (Br,J)-Emulsion; mittlerer Korn-ø = 0,07 µm, 0,5 Mol-% Iodid |
| 1,0 g | Gelatine |
| 0,05 g | farbiger Kuppler RM 1 |
| 0,10 g | Trikresylphosphat |

3. Schicht: (niedrig empfindlich rotsensibilisierte Schicht)

| | |
|---|---|
| 2,2 g | $AgNO_3$, 4 Mol-% Iodid, mittlerer Korndurchmesser 0,45 µm, rotsensibilisiert |
| 2,0 g | Gelatine |
| 0,6 g | farbloser Blaugrünkuppler C 1 emulgiert in 0,5 g Trikresylphosphat (TKP) |
| 50 mg | farbiger Blaugrünkuppler RM 1 und |
| 30 mg | DIR-Kuppler DIR 1 emulgiert in 20 mg TKP. |

4. Schicht: (hochempfindliche rotsensibilisierte Schicht)

| | |
|---|---|
| 2,8 g | $AgNO_3$, 8,5 Mol-% Iodid mittlerer Korndurchmesser 0,8 µm, rotsensibilisiert |
| 1,8 g | Gelatine |
| 0,15 g | farbloser Blaugrünkuppler C 2 emulgiert mit 0,15 g Dibutylphthalat (DBP), |

3. Schicht: (Trennschicht)

| | |
|---|---|
| 0,7 g | Gelatine |
| 0,2 g | 2,5-Diisooctylhydrochinon emulgiert mit 0,15 g DBP |

6. Schicht: (niedrigempfindliche grünsensibilisierte Schicht)

| | |
|---|---|
| 1,8 g | $AgNO_3$ einer spektral grünsensibilisierten Ag(Br,I)-Emulsion mit 4,5 Mol-% Iodid und einem mittleren Korndurchmesser von 0,4 µm, grünsensibilisiert, |
| 1,6 g | Gelatine |
| 0,6 g | Purpurkuppler M 1 |
| 50 mg | Maskenkuppler YM 1 emulgiert mit 50 mg TKP, |
| 30 mg | DIR-Kuppler DIR 2 emulgiert in 20 mg DBP |
| 30 mg | DIR-Kuppler DIR 3 emulgiert in 60 mg TKP |

7. Schicht: (hochempfindliche grünsensibilisierte Schicht)

| | |
|---|---|
| 2,2 g | $AgNO_3$, mit 7 Mol-% Iodid und einem mittleren Korndurchmesser von 0,7 µm, grünsensibilisiert, |
| 1,4 g | Gelatine |
| 0,15 g | Purpurkuppler M 2 emulgiert mit 0,45 g TKP, |
| 30 mg | Maskenkuppler gemäß 6. Schicht emulgiert mit 30 mg TKP |

8. Schicht: (Trennschicht)

| | |
|---|---|
| 0,5 g | Gelatine |
| 0,1 g | 2,5-Diisooctylhydrochinon emulgiert mit 0,08 g DBP |

9. Schicht: (Gelbfilterschicht

| | |
|---|---|
| 0,2 g | Ag (gelbes kolloidales Silbersol) |
| 0,9 g | Gelatine |
| 0,2 g | 2,5-Diisooctylhydrochinon emulgiert mit 0,16 g DBP |

10. Schicht: (niedrigempfindliche blauempfindliche Schicht)

| | |
|---|---|
| 0,6 g | $AgNO_3$, 4,9 Mol-% Iodid, mittlerer Korndurchmesser von 0,45 µm, blausensibilisiert, |
| 0,85 g | Gelatine |
| 0,7 g | Gelbkuppler Y 1 emulgiert mit 0,7 g TKP, |
| 0,5 g | DIR-Kuppler DIR 3, emulgiert mit 0,5 g TKP |

11. Schicht: (hochempfindliche blauempfindliche Schicht)

| | |
|---|---|
| 1,0 g | $AgNO_3$, 9,0 Mol-% Iodid, mittlerer Korndurchmesser 0,9 µm, blausensibilisiert |
| 0,85 g | Gelatine, |
| 0,3 g | Gelbkuppler gemäß 10. Schicht emulgiert mit 0,3 g TKP |

12. Schicht: (Schutz- und Härtungsschicht)

0,5 g AgNO$_3$ einer Mikrat-Ag(Br,I)-Emulsion, mittlerer Korndurchmesser 0,07 µm 0,5 Mol-% Iodid,
1,2 g Gelatine
0,4 g Härtungsmittel der Formel

$$(CH_2{=}CH{-}SO_2{-}CH_2{-}CONH{-}CH_2{-})_2{-}$$

1,0 g Formaldehydfänger der Formel

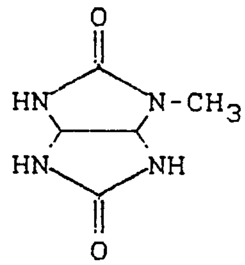

UV-1

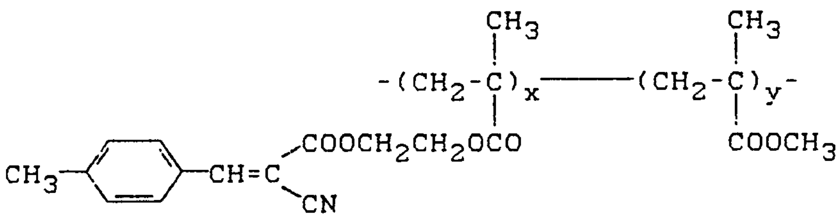

Gewichtsverhältnis: x : y = 7:3

UV-2

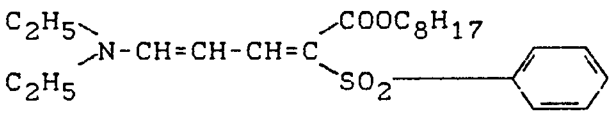

M 1

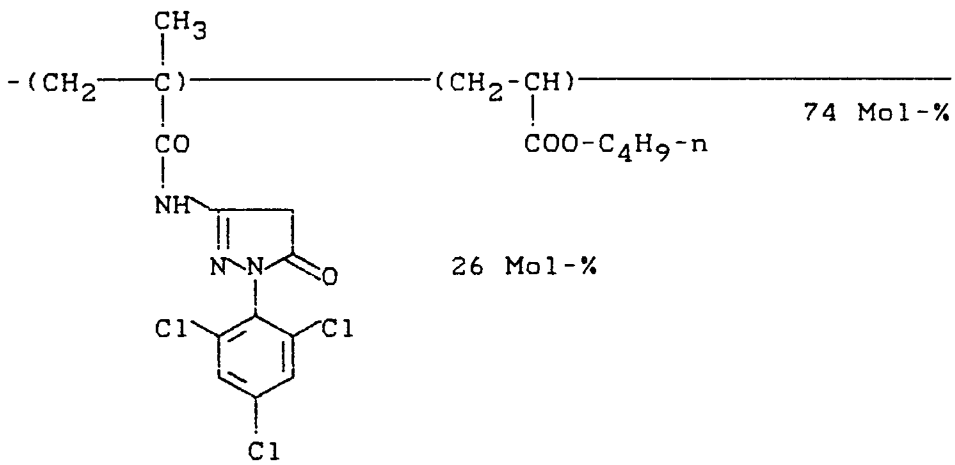

74 Mol-%

26 Mol-%

M 2

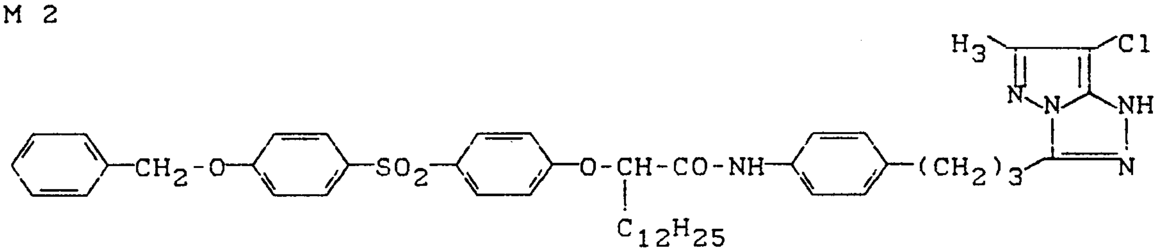

Y1

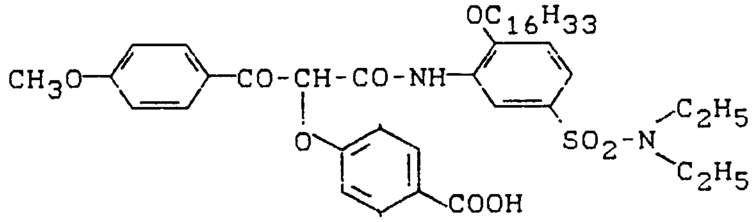

RM1

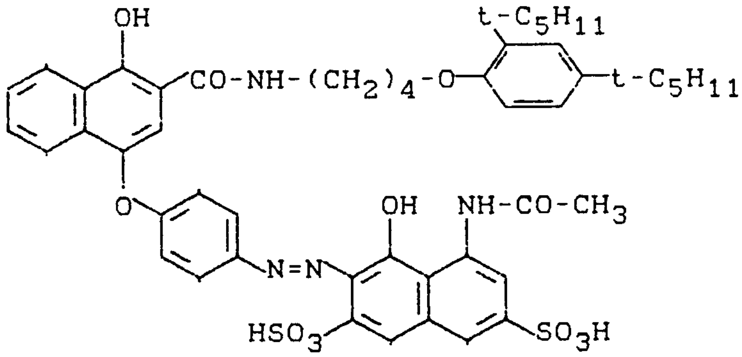

YM1

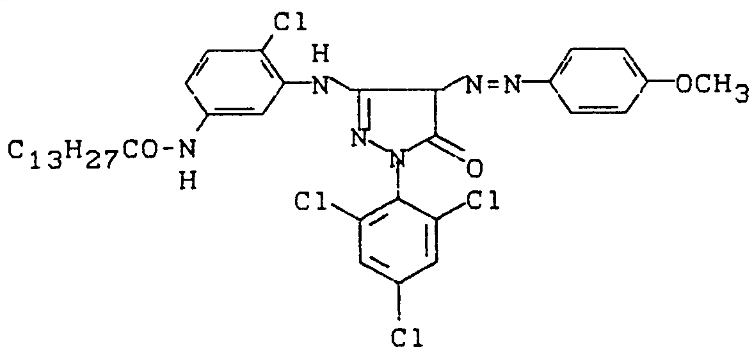

DIR 1

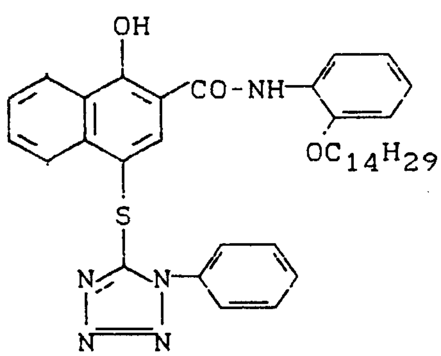

DIR 2

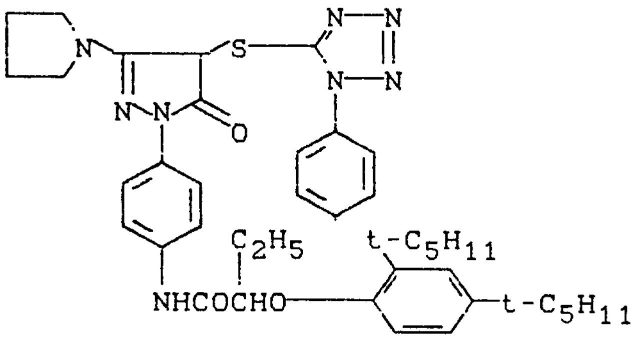

DIR 3

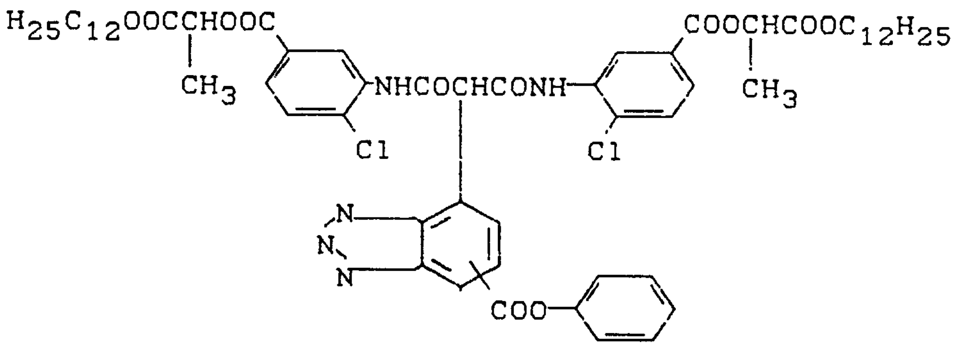

C 1

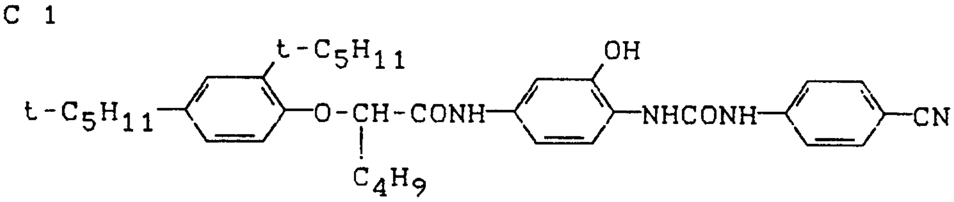

C 2

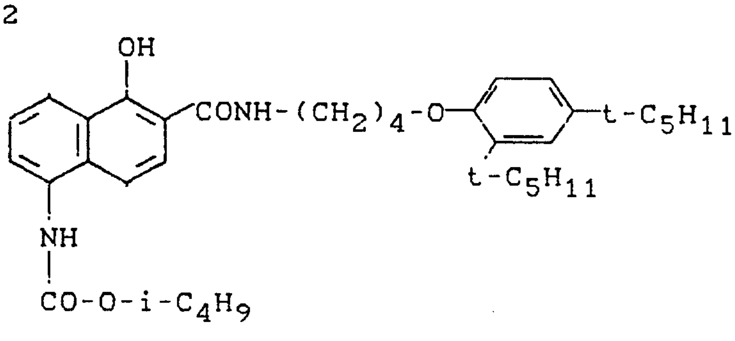

Die Gesamtschichtdicke (trocken) des Color-Aufbaus beträgt 24 µm.

Antistatikschichten (Rückseiten)

Auf die unsubstrierte Rückseite des oben beschriebenen lichtempfindlichen Colormaterials bringt man die in Tabelle 1 aufgelisteten Antistatikschichten 1a+2a mit den Deckschichten 1b+2b auf. Die Antistatikschicht 3a (ohne Deckschicht) wird auf eine rückseitig zusätzlich mit einer Haftschicht versehene Triacetat-Unterlage aufgebracht.

Die Herstellung des Antistatikums Polythiophen/PSS geschieht wie folgt:
Man versetzt eine Lösung von 1,2 g Kaliumperoxydisulfat in 200 ml Wasser unter Rühren mit 10,0 g Polystyrolsulfonsäure (MG 4000) und 2,8 g 3,4-Ethylendioxy-thiophen und rührt anschließend noch 24 Stunden bei Raumtemperatur. Danach wird die Dispersion mit 300 ml Wasser verdünnt (=Stammdispersion; Polythiophen/PSS-Gehalt; 2,6 Gew.-%).

Die in der Tabelle unter den Antistatikschichten angegebenen Leitfähigkeitswerte (gemessen als Oberflächenwiderstand (OFW) in Ohm pro Quadrat, angegeben als Ω/□ bei verschiedenen rel. Luftfeuchtigkeiten) verdeutlichen den Vorteil der erfindungsgemäßen neuen Antistatikschichten auf Polythiophenbasis:

1. Die OFW-Werte der polythiophenhaltigen Schichten sind im Vergleich zur reinen PSS-Schicht (= Vergleichstyp 1) um 2 Zehnerpotenzen niedriger;
2. auch bei sehr geringen Luftfeuchten (10 %) ändert sich die Oberflächenleitfähigkeit der Polythiophenschichten im Gegensatz zum Vergleichstyp nicht, und
3. ist die Leitfähigkeit der Polythiophenschichten permanent, d.h. sie bleibt nach der Entwicklung erhalten.

Beispiel 10

64,6 g einer Dispersion auf Basis von 47,5 Gew.-% Methacrylsäuremethylester, 47,5 Gew.-% Butadien und 5 Gew.-% 2-Acrylamido-2-methylpropansulfonsäure, Natriumsalz, mittlerer Teilchendurchmesser 171 nm, in Wasser mit einem Feststoffgehalt von 31 Gew.-% werden mit 500 ml Wasser verdünnt. Nach Zugabe von 5,4 g Kaliumperoxidisulfat, 2,0 g Polystyrolsulfonsäure und 8,0 g 3,4-Ethylendioxythiophen wird die Dispersion 24 Stunden bei Raumtemperatur gerührt. Während dieser Zeit wird Luft durch die Dispersion geleitet.

Die Zubereitung wird in einer Menge von 200 mg/$m^2$ (Trockensubstanz) auf eine Polyesterfolie gegossen. Nach dem Trocknen erhält man eine klare Beschichtung mit einer optischen Dichte von 0,01 im ortho-Bereich (weißes Licht)

und einem Oberflächenwiderstand von 6·10⁷ Ω/□.

Tabelle 1

| Antistatikschicht | | Vergleichsbeispiel | | |
|---|---|---|---|---|
| | | 1a | 2a | 3a |
| Polystyrolsulfonsäure-Na-Salz (13 gew.-%ig in $H_2O$) [ml] | | 33 | - | - |
| Polythiophen/PSS [g] | | - | 3 | 3 |
| Wasser [ml] | | 2 | 247 | 484 |
| Methanol [ml] | | 365 | 100 | 500 |
| Aceton [ml] | | 600 | 650 | - |
| Netzmittel (4 gew.-%ig in Wasser) | | - | | 10 |
| Polyethylendispersion (5 gew.-%ig in $H_2O$) [ml] | | - | - | 3 |
| Naßauftrag [ml] | | 16 | 20 | 20 |
| Deckschicht | | 1b | 2b | - |
| Cellulosediacetat (10 gew.-%ig in Aceton [ml] | | 20 | 20 | |
| Methanol [ml] | | 530 | 330 | |
| Aceton [ml] | | 430 | 630 | |
| Wasser [ml] | | 19 | 17 | |
| Polyethylendispersion (5 gew.-%ig in $H_2O$ [ml] | | 1 | 3 | |
| Naßauftrag [ml] | | 15 | 15 | |
| OFW [Ω/□ ] | bei 50 % RF | $2\cdot10^9$ | $5\cdot10^7$ | $3\cdot10^7$ |
| | bei 10 % RF | $5\cdot10^{10}$ | $6\cdot10^7$ | $3\cdot10^7$ |
| nach der Entwicklung bei 50 % RF | | $> 10^{12}$ | $9\cdot10^7$ | $6\cdot10^7$ |
| opt. Dichte (weiß) | | 0,06 | 0,07 | 0,07 |

Beispiel 11

a) Herstellung des Polythiophens:

In eine Lösung aus 50 g Polystyrolsulfonsäure, 6,0 g Kaliumperoxidisulfat und 14,0 g 3,4-Ethylendioxythiophen in 1000 ml Wasser wird 24 Stunden bei Raumtemperatur unter Rühren Luft eingeblasen. Die Zubereitung hat einen Feststoff-Gehalt von 5,7 Gew.-% (1 h 100°C) und ist gebrauchsfertig.

b) Herstellung der Antistatikschicht:

Auf eine Polyethylen-terephthalat-Unterlage (PET), die mit einer Haftschicht aus einem Terpolymerlatex aus Vinylidenchlorid/Methacrylat/Itaconsäure und kolloidaler Kieselsäure mit einer Oberfläche von 100 $m^2$/g versehen ist, bringt man eine Zusammensetzung aus 66 ml der obigen Polythiophenzubereitung und 2 ml einer 5 gew.-%igen Netzmittellösung in 932 ml Wasser auf.

Naßauftrag; 50 $m^2$/l: Gießgeschwindigkeit: 5 m/min: Trockentemperatur: 120°C/2 min.

Man erhält eine nahezu farblose Schicht mit folgenden Oberflächenleitfähigkeiten:

| | | |
|---|---|---|
| OFW [Ω/□] bei 30 % RF | vor fotografischer Verarbeitung: | $0{,}7\cdot10^9$ |
| | nach fotografischer Verarbeitung: | $4\cdot10^9$ |

Die Schicht ist also permanent antistatisch.

Beispiel 12

Die gemäß Beispiel 11 hergestellte Antistatikschicht wird zusätzlich mit einer Deckschicht aus 1 g $m^2$ Polymethylmethacrylat (PMMA) überschichtet. Diese wird aus einem Lösungsmittelgemisch aus Aceton/Methoxypropanol 80/20 vergossen. Die transparente Antistatikschicht hat folgende Oberflächenwiderstände [Ω/□].

| | 30 % RF/21°C | 60 % RF/21°C |
|---|---|---|
| vor fotografischer Entwicklung | $1{,}6 \cdot 10^{10}$ | $0{,}15 \cdot 10^{10}$ |
| nach fotografischer Entwicklung | $1 \cdot 10^{10}$ | $0{,}03 \cdot 10^{10}$ |

Mißt man kapazitiv die Abklingzeit der elektrischen Aufladung [RC in msec] so erhält man folgende Werte:

| | 30 % RF/21°C |
|---|---|
| vor fotografischer Entwicklung | 0,53 |
| nach fotografischer Entwicklung | 1,1 |

Wie aus den Werten ersichtlich ist, zeigen die erfindungsgemäßen Antistatikschichten neben hoher Leitfähigkeit sehr gute Permanenz, wobei die Oberflächenleitfähigkeit nach Entwicklung noch zunimmt.

Beispiel 13

Besonders gute Oberflächenleitfähigkeiten erhält man mit einer Antistatikschicht der folgenden Zusammensetzung:

| | |
|---|---|
| Polythiophenzubereitung gem. Beispiel 11 (5,7 gew.-%ig) | 66 ml |
| Wasser | 820 ml |
| Isopropanol | 100 ml |
| Polyurethandispersion, 40 gew.-%ig | 1,5 ml |
| Polyethylendispersion, 2,5 gew.-%ig | 15 ml |
| Netzmitel, 10 gew.-%ig | 1,5 ml |
| | 1000 ml |

Auftrag: 30 m²/l; Gießgeschwindigkeit: 8 m/min; Trockentemperatur 130°C/1,25 min

| OFW [Ω/□]: | 30 % RF/21°C | 60 % RF/21°C |
|---|---|---|
| vor fotografischer Entwicklung | <0,1 · $10^8$ | <0,1 · $10^8$ |
| nach fotografischer Entwicklung | 3 · $10^8$ | |
| RC [sec] | | |
| vor fotografischer Entwicklung | <0,0064 | |
| nach fotografischer Entwicklung | 0,05 | |

Überschichtet man diese Antistatikschicht mit einer Deckschicht aus PMMA gemäß Beispiel 12, so mißt man etwas geringere Oberflächenleitfähigkeiten (= höhere OFW-Werte), die für Verblitzungen entscheidende kurze Abkingzeit für elektrostatische Aufladungen bleibt unverändert kurz, vor allem auch noch nach der Entwicklung.

| OFW [Ω/□]: | 30 % RF/21°C | 60 % RF/21°C |
|---|---|---|
| vor fotografischer Entwicklung | 3 · $10^9$ | 0,04 · $10^9$ |
| nach fotografischer Entwicklung | 0,3 · $10^9$ | |
| RC [msec] | | |
| vor fotografischer Entwicklung | <0,0064 | |
| nach fotografischer Entwicklung | <0,0064 | |

| | | |
|---|---|---|
| Optische Dichte der Schichten: | Ortho: (350-630 nm) | 0,01 |
| | UV: (370 nm) | 0,01 |

## Patentansprüche

**1.** Dispersionen von Polythiophenen, die aus Struktureinheiten der Formel

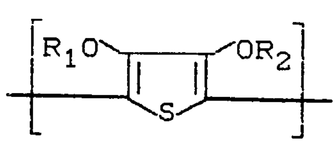

(I),

aufgebaut sind, in der

$R_1$ und $R_2$ zusammen einen gegebenenfalls substituierten $C_1$-$C_4$-Alkylen-Rest bilden,

in Gegenwart von Polyanionen der Polystyrolsulfonsäure.

**2.** Polythiophen-Dispersionen gemäß Anspruch 1, dadurch gekennzeichnet, daß $R_1$ und $R_2$ zusammen einen gegebenenfalls durch Alkylgruppen substituierten Methylen-, einen gegebenenfalls durch $C_1$-$C_{12}$-Alkyl- oder Phenylgruppen substituierten Ethylen-1,2-Rest, einen Propylen-1,3-Rest oder einen Cyclohexylen-1,2-Rest bilden.

3. Verfahren zur Herstellung der Polythiophen-Dispersionen gemäß Anspruch 1, dadurch gekennzeichnet, daß man Verbindungen der Formel

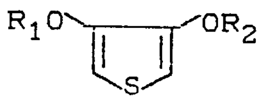

(II),

in der

$R_1$ und $R_2$ die in Anspruch 1 angegebene Bedeutung haben,

mit für die oxidative Polymerisation von Pyrrol üblichen Oxidationsmitteln und/oder Sauerstoff oder Luft in Gegenwart von Polystyrolsulfonsäure bei Temperaturen von 0 bis 100°C oxydativ polymerisiert.

4. Verfahren zur antistatischen Ausrüstung von Kunststoff-Formteilen, dadurch gekennzeichnet, daß man Polythiophendispersionen gemäß Anspruch 1 einsetzt.

5. Verfahren zur antistatischen Ausrüstung von Kunststoff-Formteilen, dadurch gekennzeichnet, daß man wäßrige Zubereitungen der Polythiophendispersionen einsetzt.

6. Verfahren zur antistatischen Ausrüstung von fotografischen Materialien, dadurch gekennzeichnet, daß man eine Schicht, enthaltend Polythiophendispersionen gemäß Anspruch 1 aufträgt.

7. Verfahren nach Anspruch 6, dadurch gekennzeichnet, daß man die Polythiophendispersionen in einer Menge von 0,001 bis 0,3 $g/m^2$ einsetzt.

8. Fotografisches Material mit einer Antistatikschicht, dadurch gekennzeichnet, daß die Schicht wenigstens ein Polythiophenpolysäure-Zubereitung gemäß Anspruch 1 aufweist.

**Claims**

1. Dispersions of polythiophenes synthesized from structural units corresponding to the following formula:

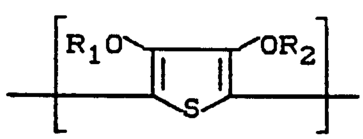

(I),

in which

$R_1$ and $R_2$ together form an optionally substituted $C_{1-4}$ alkylene group,

in the presence of polyanions of polystyrenesulfonic acid.

2. Polythiophene dispersions as claimed in claim 1, characterized in that, in formula (I), $R_1$ and $R_2$ together represent an optionally alkyl-substituted methylene group, an optionally $C_{1-12}$-alkyl- or phenyl-substituted 1,2-ethylene group, a 1,3-propylene group or a 1,2-cyclohexylene group.

3. A process for the production of the polythiophene dispersions claimed in claim 1, characterized in that compounds corresponding to the following formula:

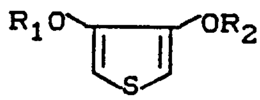 (II),

in which

$R_1$ and $R_2$ are as defined in claim 1,

are oxidatively polymerized with oxidizing agents typically used for the oxidative polymerization of pyrrole and/or with oxygen or air in the presence of the polystyrenesulfonic acid at temperatures of 0 to 100°C.

4. A process for the antistatic treatment of plastic mouldings, characterized in that the polythiophene dispersions claimed in claim 1 are used.

5. A process for the antistatic treatment of plastic mouldings, characterized in that agueous preparations of the polythiophene dispersions are used.

6. A process for the antistatic treatment of photographic materials, characterized in that a layer containing the polythiophene dispersions claimed in claim 1 is applied.

7. A process as claimed in claim 6, characterized in that the polythiophene dispersions are applied in a quantity of 0.001 to 0.3 g/m$^2$.

8. A photographic material with an antistatic layer, characterized in that the layer contains at least one polythiophene polyacid preparation according to claim 1.

**Revendications**

1. Dispersions de polythiophènes constitués de motif de structure de formule :

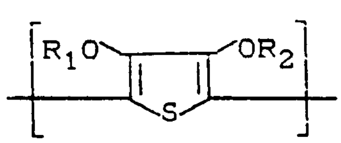 (I),

dans laquelle
$R_1$ et $R_2$ forment ensemble un groupe alkylène en $C_1$-$C_4$ éventuellement substitué,
en présence de polyanions de l'acide polystyrènesulfonique.

2. Dispersions de polythiophènes selon la revendication 1, caractérisées en ce que $R_1$ et $R_2$ représentent ensemble un groupe méthylène éventuellement substitué par des groupes alkyles, un groupe 1,2-éthylène éventuellement substitué par des groupes alkyles en $C_1$-$C_{12}$ ou phényle, un groupe 1,3-propylène ou un groupe 1,2-cyclohexylène.

3. Procédé de préparation des dispersions de polythiophènes selon la revendication 1, caractérisé en ce que l'on soumet des composés de formule :

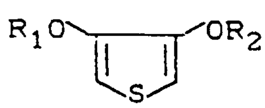 (II),

dans laquelle
$R_1$ et $R_2$ ont les significations indiquées dans la revendication 1,
à polymérisation oxydative à des températures de 0 à 100°C avec les agents oxydants usuels pour la polymérisation oxydative du pyrrole et/ou avec l'oxygène ou l'air, en présence d'acide polystyrènesulfonique.

**4.** Procédé pour le traitement antistatique de pièces moulées en résines synthétiques, caractérisé en ce que l'on utilise des dispersions de polythiophènes selon la revendication 1.

**5.** Procédé pour le traitement antistatique de pièces moulées en résines synthétiques, caractérisé en ce que l'on utilise des compositions aqueuses des dispersions de polythiophène.

**6.** Procédé pour le traitement antistatique de matériaux photographiques, caractérisé en ce que l'on applique une couche contenant des dispersions de polythiophènes selon la revendication 1.

**7.** Procédé selon la revendication 6, caractérisé en ce que l'on applique les dispersions de polythiophènes en quantité de 0,001 à 0,3 $g/m^2$.

**8.** Matériau photographique portant une couche antistatique, caractérisé en ce que la couche contient au moins une composition de polythiophène-polyacide selon la revendication 1.